Europäisches Patentamt

European Patent Office

Office européen des brevets

(11) Veröffentlichungsnummer : **0 009 131**
**B1**

(12) # EUROPÄISCHE PATENTSCHRIFT

(45) Veröffentlichungstag der Patentschrift :
23.12.81

(21) Anmeldenummer : 79103107.3

(22) Anmeldetag : 23.08.79

(51) Int. Cl.$^3$ : **B 23 K 35/36**, B 23 K   1/02,
**H 01 L 23/48**

(54) **Verfahren zur in situ Änderung der Zusammensetzungen von Lötlegierungen.**

(30) Priorität : 20.09.78 US 944224

(43) Veröffentlichungstag der Anmeldung :
02.04.80 (Patentblatt 80/07)

(45) Bekanntmachung des Hinweises auf die Patenterteilung : 23.12.81 Patentblatt 81/51

(84) Benannte Vertragsstaaten :
DE FR GB

(56) Entgegenhaltungen :
US - A - 2 043 573
US - A - 3 380 821
US - A - 3 478 414

FEINWERKTECHNIK, Band 76, 1972, Heft 13, Seiten 130-134, München, DE.
P.A. AINSWORTH : « Beeinflussung der mechanischen Eigenschaften von Weichlötverbindungen in elektronischen Ausrüstungen »

(73) Patentinhaber : **International Business Machines Corporation**

**Armonk, N.Y. 10504 (US)**

(72) Erfinder : **Koopman, Nicholas George**
**9 Francis Drive**
**Hopewell Junction, N. Y. 12533 (US)**
Erfinder : **Marcotte, Vincent Charles**
**Kuchler Drive, RD No. 1**
**La Grangeville, N. Y. 12540 (US)**
Erfinder : **Teed, Stephen**
**So. Fowler House Road**
**Wappingers Falls, N. Y. 12590 (US)**

(74) Vertreter : **Kreidler, Eva-Maria, Dr. rer. nat.**
**Schönaicher Strasse 220**
**D-7030 Böblingen (DE)**

## Verfahren zur in-situ Änderung der Zusammensetzungen von Lötlegierungen

Die Erfindung betrifft ein Verfahren zur in-situ Änderung der Zusammensetzungen von Lötlegierungen mit einem Gehalt an Blei und einem Netzmittel, beispielsweise Zinn oder Indium. Bei diesem Verfahren wird der Bleigehalt in der Legierung der gelöteten Verbindung erhöht, was besonders bei der Halbleiterfertigung von Bedeutung ist.

Es ist bekannt, daß reines Blei zur Herstellung von Lötverbindungen nicht geeignet ist, weil es nicht benetzend wirkt, was für gute Lötverbindungen unbedingt erforderlich ist. Gute Lötverbindungen werden beispielsweise mit Bleilegierungen, wie 95 : 5 Blei/Zinn oder 95 : 5 Blei/Indium erhalten.

Lötverbindungen aus reinem Blei oder einer Legierung mit einem hohen Bleigehalt würden jedoch im Vergleich mit konventionellen Lötlegierungen ein 2- bis 3 mal besseres Verhalten hinsichtlich der Ermüdung aufweisen. Auch würden Lötverbindungen aus im wesentlichen reinem Blei eine erhöhte Kriechfestigkeit unter Dauerbelastung verglichen mit der eines 50 : 50 Blei/Indiumlots aufweisen. In diesem Zusammenhang werden auf die US-Patentschrift 3 380 821 und auf die Veröffentlichung von R. Herdzik et a. « Blinde Anschlußstellen für erhöhte Kriechbeständigkeit », IBM Technical Disclosure Bulletin, Vol. 20, Nr. 4, September 1977, Seite 1 394 hingewiesen. Bisher ist kein vernünftiges Verfahren bekannt, Blei-Lötverbindungen ohne einen wesentlichen Gehalt an Netzmitteln, wie Zinn oder Indium herzustellen.

Aufgabe der Erfindung ist deshalb die Bereitstellung eines Verfahrens zur in-situ Änderung der Zusammensetzungen von Lötlegierungen mit einem Gehalt an Blei und einem Netzmittel.

Die Aufgabe der Erfindung wird gelöst durch ein Verfahren der eingangs genannten Art, das dadurch gekennzeichnet ist, daß die Lötlegierungen in geschmolzener Form eine ausreichende Zeit lang in Kontakt mit einem Lötflußmittel erhitzt werden, um den Gehalt an Netzmittel in der geschmolzenen Lötlegierung herabzusetzen.

Vorteilhafte Ausgestaltungen der Erfindung sind in den abhängigen Ansprüchen angegeben. Mit dem erfindungsgemäßen Verfahren können Lötverbindungen mit einer erhöhten Beständigkeit hinsichtlich Ermüdung und auch mit erhöhter Kriechfestigkeit im Vergleich mit bisher bekannten Lötlegierungen erhalten werden. Die Zusammensetzung der Lötlegierung kann dabei nach Herstellung der Verbindungsstelle durch die Einwirkung eines geeigneten Lötflußmittels geändert werden, indem der Bleigehalt der Lötverbindungen auf einen gewünschten Wert erhöht wird.

Die Erfindung wird anhand der Figuren und der Beschreibung näher erläutert.

Fig. 1 ist ein vergrößerter Querschnitt einer Struktur, die bei der Herstellung eines Lötanschlusses erhalten wird.

Fign. 1A und 1B sind Elektronenmikroskopaufnahmen bei 700 facher Vergrößerung und einem Winkel von 60° der Struktur von Fig. 1 und einer Lötanschlußstelle, die erfindungsgemäß ausgelaugt wurde.

Fig. 2 ist ein binäres Phasendiagramm von Blei/Indium in Gleichgewicht.

In Fig. 3 ist das Auslaugen von Indium aus einer 50 : 50 Indium/Blei-Lötanschlußstelle mit Abhängigkeit von der Zeit dargestellt.

In Fig. 5 ist das thermische Profil eines Ofens, der auf 280 °C gehalten wird, dargestellt.

Fign. 6A und 6B zeigen den Zustand von Lötverbindungen während der Erhöhung des Gehalts an Blei, wie sie in der Halbleiterfertigung angewendet werden.

Es wurde gefunden, daß der Bleigehalt in Lötverbindungen aus einer Bleilegierung durch Modifizieren derselben erhöht werden kann, insbesondere bei einem Verfahren, bei dem die integrierten Halbleiterchips vor dem Auflöten auf die Substrate gewendet und dann aufgelötet werden. Zur Ausbildung von Lötverbindungen dieser Art werden konventionelle Lote, beispielsweise 95 : 5 Blei/Zinn und 95 : 5 Blei/Indium oder 50 : 50 Blei/Indium Lote verwendet, und anschließend wird das überschüssige Zinn oder Indium aus den resultierenden Verbindungen mit einem Flußmittel, welches wenigstens eine Harzsäure enthält, die aus der Gruppe der Monocarbonsäuren eines alkylierten Hydrophenanthrengerüsts mit der empirischen Formel $C_{19}H_{20}COOH$ gewählt ist, entfernt. Auf diese Weise wird durch das Flußmittel bei erhöhten Temperaturen der Zinngehalt einer 95 : 5 Blei/Zinn-Lötverbindung auf weniger als 1 Gew.% erniedrigt. Indium reagiert noch leichter und kann aus einer Blei/Indium-Lötverbindung noch leichter ausgelaugt werden.

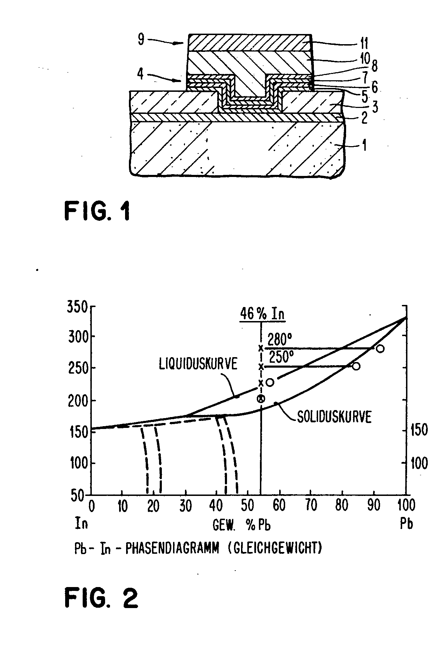

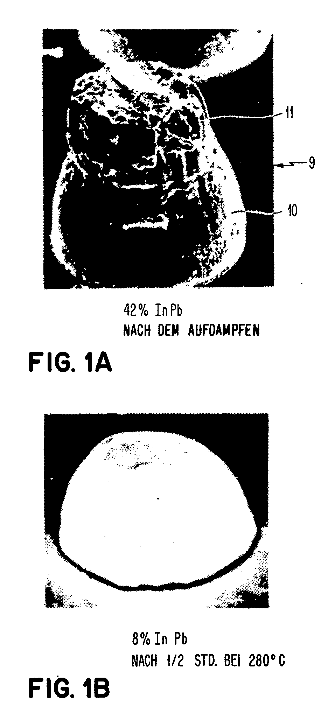

In der Mehrzahl der beschriebenen Experimente werden Halbleiterchips 1 verwendet, die nachfolgend als integrierte Halbleiterchips bezeichnet werden (Fig. 1) und aus einer ersten Aluminiummetallisierung 2, einer Siliciumdioxidschicht 3 und einer Kontaktstelle 4 bestehen, wobei letztere aus einer 200 nm dicken Chromschicht 5, einer 1 000 nm dicken Kupferschicht 6 mit einer anfänglichen, etwa 80 nm dicken Schicht einer Chromkupferphase und einer 140 nm dicken Goldschicht 8 gebildet wird. Ein Beispiel dieser Art ist in Fig. 1 der IBM Technical Disclosure Bulletin-Veröffentlichung « Entfernungsverfahren » von C. Johnson et al., in Vol. 20, Nr. 6, November 1977, auf den Seiten 2 209 bis 2 210 beschrieben. Jedes integrierte Halbleiterchip enthält 121 solcher Kontaktstellen 4.

Wafer, welche integrierte Halbleiterchips dieser Art enthalten, werden nachfolgend als integrierte Halbleiterwafer bezeichnet, wobei jeder Wafer einige 100 integrierte Halbleiterchips enthält. Die Lötanschlußstelle 9 wurde auf die Kontaktstellen 4 in einer Höhe von 0,114 3 mm durch eine Maske aufgedampft. Wegen des höheren Dampfdrucks von Blei wird dieses zuerst in einer Schicht 10 aufgedampft, und anschließend erfolgt das Aufdampfen von Indium in einer Schicht 11. Die Form der aufgedampfen Lötanschlußstellen war die eines Kegelstumpfs. Der Ausdruck « Nachträgliches Benetzen », der hier verwendet wird, bezeichnet ein Aufschmelzen zur Modifizierung der Lötanschlußstellen, beispielsweise um die beiden Schichten der Lötanschlußstelle 4 miteinander zu verschmelzen und dadurch das Netzmittel, die Indium-/oder Zinnschicht 11, dem Blei als Lötlegierung einzuverleiben.

Die Zusammensetzungen der Lötlegierungen einschließlich aller Lötanschlußstellen wurden durch Messung ihrer Schmelzpunkte unter Anwendung eines Perkin-Elmer-Differentialkalorimeters (Differential Scanning Calorimetry, abgekürzt DSC) bestimmt. Weil experimentell leichter durchführbar, wurden bei den Messungen die Abkühlungskurven verwendet. Aus bekannten Zusammensetzungen wurden Standards hergestellt und unter den gleichen Bedingungen wie die Lötlegierungen und die Lötanschlußstellen unter Verwendung der gleichen Materialmengen untersucht.

Die Mehrzahl der Experimente wurde in einem Rohrofen einer Stickstoffatmosphäre durchgeführt. Die Proben wurden in ein Becherglas gegeben, mit dem auslaugenden Flußmittel bedeckt und auf einer Glasplatte, an der ein Thermoelement befestigt war, in den Ofen gestellt.

Die Flußmittel, welche verwendet wurden, waren von Alpha Metals, beispielsweise $\alpha$-102-1 500 mit einem Zusatz von 20 % Isopropylalkohol (IPA), bezogen auf das Gewicht von $\alpha$-102-1 500, und $\alpha$-100-40. Es wurden auch wasserhelles Kolophonium und ein wasserlösliches Flußmittel mit der Bezeichnung TBC, welches aus 50 Vol. % Triäthanolamin und 50 Vol. % Butylglykol (Butylcellosolve) bestand, verwendet. Das $\alpha$-102-1 500-Flußmittel wird nachfolgend als $\alpha$-102 bezeichnet, wobei die zweite Hälfte der Zahlenangabe (1 500) die Viskosität des Flußmittels angibt. In ähnlicher Weise wird das $\alpha$-100-40-Flußmittel nachfolgend als $\alpha$-104 bezeichnet. Das $\alpha$-102-Flußmittel wird als 68 Gew.%ige Lösung von Abietinsäure in Benzylalkohol und das $\alpha$-104-Flußmittel als 40 Gew.%ige Lösung von Abietinsäure in Isopropanol geliefert. Wasserhelles Kolophonium ist eine Harzsäure vom Typ der Monocarbonsäuren des alkylierten Hydrophenanthrengerüsts mit einer empirischen Formel $C_{19}H_{29}COOH$.

In den beiden ersten Experimenten wurden zwei integrierte Halbleiterwafer, die 200 integrierte Halbleiterchips enthielten, verwendet und einem vollständigen Verfahren mit aufeinanderfolgender Abscheidung von 50 : 50 Indium/Blei-Anschlüssen 9, d.h. einer Bleischicht 10 und einer Indiumschicht 11 (Fign. 1 und 1A) unterworfen. Auf die Hälfte eines Wafers wurde über den Lötanschlüssen das $\alpha$-102-Flußmittel aufgetragen, diese wurden zwei Minuten lang bei 275 °C aufgeschmolzen, was nachfolgend mit auslaugendem Aufschmelzen bezeichnet wird. Nach dem auslaugenden Aufschmelzen wurde dieser Teil der Waferhälfte zwei Minuten lang bei 275 °C in einer Stickstoffatmosphäre einer zweiten Aufschmelzbehandlung unterworfen. Der restliche halbe Wafer wurde beiden Aufschmelzbehandlungen in umgekehrter Reihenfolge, d.h., zuerst einer zwei Minuten dauernden Aufschmelzbehandlung bei 275 °C in Stickstoffatmosphäre und dann einer zwei Minuten dauernden Aufschmelzbehandlung mit $\alpha$-102-Flußmittel bei 275 °C unterworfen.

Die Ergebnisse sind in der nachfolgenden Tabelle I aufgetragen. Es ist ersichtlich, daß die Aufschmelzbehandlung in Stickstoffatmosphäre keinen Einfluß auf die Indiumkonzentration ausübt, während die Indiumkonzentration durch das auslaugende Aufschmelzen mit $\alpha$-102-Flußmittel reduziert wird.

Tabelle I

Untersuchung über den relativen Einfluß des Aufschmelzverfahrens mit Stickstoff und $\alpha$-102-Flußmittel auf den Indiumgehalt der Lötanschlußstellen. Wafer mit einem Sollwert 50 von Indium/Blei nach Durchlauf durch einen Ofen zur nachträglichen Benetzung.

| Verfahren | Indiumkonzentration* |
|---|---|
| Probe 1 | |
| Nach dem Aufdampfen | 46 % |
| Aufschmelzen mit Flußmittel | 39 % |
| Aufschmelzen mit Flußmittel unter Stickstoff | 40 % |
| | |
| Probe 2 | |
| Nach dem Aufdampfen | 46 % |
| Aufschmelzen unter Stickstoff | 44 % |
| Aufschmelzen mit Flußmittel unter Stickstoff | 40 % |

\* bestimmt aus Schmelzpunkten, die mit dem Differentialkalorimeter ermittelt wurden.

Im nächsten Versuch wurden einzelne Wafersegmente, welche je drei integrierte Halbleiterchips enthielten (aus dem integrierten Halbleiterwafer abgeteilt), in ein Becherglas gegeben und mit verschiedenen Flußmitteln für Reaktionszeiten und Temperatur bedeckt. Zusätzlich wurde eine Kontrollprobe angewendet, bei der die Lötanschlußstelle nur in Stickstoffatmosphäre aufgeschmolzen wurde. In jedem Fall hatten die Proben eine Kontaktstelle 4. Es wurden auch Proben angewendet, bei denen die Lötanschlußstelle 9 direkt auf eine blanke Siliciumsubstratoberfläche aufgedampft war. Die nachfolgende Tabelle II zeigt den Effekt des Auslaugens von Indium durch verschiedene Flußmittel während einer halben Stunde bei 280 °C.

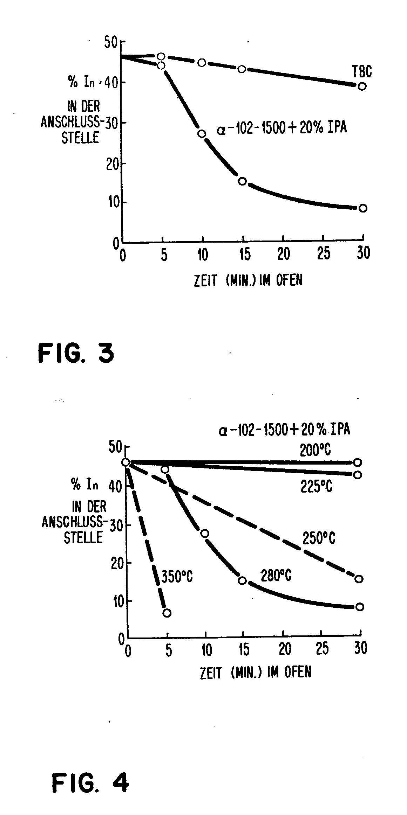

Die Erfindung gestattet auch die Reparatur oder den Ersatz eines oder mehrerer Chips einer Vielzahl von Chips, die mit einem Träger, beispielsweise einem mehrschichtigen Keramiksubstrat durch ein hochschmelzendes Lot, beispielsweise ein 85 % Blei/15 % Indiumlot (Fig. 2) verbunden sind. Bei dieser Anwendung kann das Chip, weil die Lötstellen außerordentlich klein sind, mechanisch abgetrennt oder von dem Träger entfernt werden. Anschließend wird ein neues Chip auf der freigewordenen Stelle angeordnet, wobei das Chip mit einem niedrigschmelzenden Lot, beispielsweise einem 55 % Blei/45 % Indiumlot versehen ist, und die Einheit wird auf eine Temperatur (beispielsweise 250 °C, Fig. 2), die über dem Schmelzpunkt des 55 Blei/45 Indiumlots, aber unter dem Schmelzpunkt des 85 Blei/15 Indiumlots liegt, erhitzt, um die Zusammensetzung 55 Blei/45 Indium isothermisch in 85 Blei/15 Indium zu ändern, d.h., um das Lot in dem Solidusteil des Phasendiagramms zu positionieren. Auf diese Weise können einzelne Chips auf einer Anordnung mit vielen Chips ersetzt werden, ohne daß die Lötstellen der übrigen Chips aufgeschmolzen werden müssen.

## TABELLE II

Effekt des Auslaugens von Indium aus einem 50 : 50 Indium/Bleilot durch verschiedene Flußmittel — 280 °C, 1/2 Stunde.

| | Mit Kontaktstelle Indiumgehalt | | | Ohne Kontaktstelle Lötanschlußstellen direkt auf Siliciumoberfläche angebracht Indiumgehalt mit DSC* |
|---|---|---|---|---|
| Gewichtsverlust[1] mg | | Gewichtsverlust | mit DSC* | |
| α-102 | 1,6 | 8 % | 8 %** | 12 %** |
| TBC | 0,5 | 38 % | 38 % | 40 % |
| α-100-40 | 1,3 | 19 % | 10 % | |
| α-102 | 1,6 | 8 % | 8 % | |
| Abietinsäure | 1,5 | 12 % | 6 %** | |
| Kontrollwert | 0 | 46 % | 46 % | 49 % |
| Ohne Aufschmelzen | | | 46 % | 48 % |

* aus Differentialkalorimetermessungen
** Indiumgehalt des Flußmittels, festgestellt durch Emissionsspektroskopie
[1]Gewicht des Chips vor und nicht nach dem Gewichtsverlust.

Wie aus Tabelle II ersichtlich ist, ändert sich der Indiumgehalt der Kontrollprobe während des Erhitzens nicht und war der gleiche wie der einer nicht erhitzten Probe. Alle Flußmittel auf Basis von Kolophonium (α-102, α-104 und Abietinsäure) bewirkten eine große Herabsetzung des Indiumgehalts. Das wasserlösliche TBC (Triäthanolamin/Butylcellosolve) bewirkte nur eine geringfügige Abnahme des Indiumgehalts der Lötanschlußstellen. Chips ohne Kontaktstellen wiesen einen höheren Indiumgehalt auf, was das Fehlen des Einflusses der Kupfer- und Goldmetallurgie wiederspiegelte. Der Indiumgehalt, welcher durch den Gewichtsverlust bestimmt wurde, zeigte geringfügige Schwankungen, welche einer nicht ausreichenden Reinigung der Proben nach dem auslaugenden Aufschmelzen zugeschrieben wurden.

In den Fign. 1A und 1B sind Elektronenmikroskopaufnahmen zweier Lötanschlußstellen gezeigt ; eine unmittelbar nach dem Aufdampfen und die andere eine halbe Stunde nach dem auslaugenden Aufschmelzen bei 280 °C in α-102 Flußmittel. Die Indiumbedeckung 11 ist auf der aufgedampften Lötanschlußstelle sichtbar, wie auch die Änderung des Volumens der Lötanschlußstelle durch das Erhitzen in dem Flußmittel, welche die Abnahme des Indiums aus der Lötstelle wiederspiegelt.

Die Temperaturabhängigkeit der Entfernung von Indium durch Auslaugen aus 50 : 50 Indium/Blei Lötanschlußstellen ist in der nachfolgenden Tabelle III gezeigt.

## Tabelle III

Temperatureinflüsse auf das Auslaugen von Indium aus 50 : 50 Indium/Blei Lötanschlüsse. α-102-1 500 + 20 % IPA (Isopropylalkohol)-Flußmittel, 1/2 Stunde bei den angegebenen Temperaturen.

| Temperatur °C | Gewichtsverlust mg | Indiumgehalt Gewichtsverlust | DSC* |
|---|---|---|---|
| 280 °C | 1,6 | 8 % | 8 % |
| 250 °C | 1,1 | 25 % | 15 % |
| 225 °C | 0,24 | 42 % | 42 % |
| 200 °C | 0,1 | 45 % | 45 % |

* Differentialkalorimeter

In Tabelle III wurden alle Chips eine halbe Stunde auf den angegebenen Temperaturen gehalten. Die gleichen Ergebnisse sind in dem Indium-Phasendiagramm in Fig. 2 aufgetragen, welches graphisch die Abnahme von Indium bei 280 °C und 250 °C zeigt.

Die Zeitabhängigkeit der α-102- und TBC (Triäthanolamin-Butylcellosolve)-Reaktionen wurde bei 280 °C an 50 : 50 Indium/Blei-Lötanschlußstellen bestimmt. Das α-102-Flußmittel wurde bei 280° mit den auf den Chips aufgedampften Lötanschlußstellen und mit denselben nach einem zuerst durchgeführten Aufschmelzen umgesetzt : Ein Unterschied zwischen den beiden konnte, wie aus Tabelle IV ersichtlich ist, nicht festgestellt werden.

Tabelle IV

Einfluß der Behandlungszeit bei 280 °C auf das Auslaugen von Indium aus 50 : 50 Indium/Blei Anschlußstellen.

% Indium, welches in den Anschlußstellen zurückbleibt (Differentialkalorimeter)

| Zeit im Ofen | TBC aufgedampft | α-102-1 500+20 % IPA ; aufgedampft | mit vorherigem Aufschmelzen in Stickstoffatmosphäre |
|---|---|---|---|
| 0 Min. | 46 | 46 | 46 |
| 5 Min. | 46 | 44 | 44 |
| 10 Min. | 45 | 27 | 29 |
| 15 Min. | 43 | 15 | 15 |
| 30 Min. | 38 | 8 | 8 |

5 Min. bei 350° mit α-102, 7 % Indium zurückbleibend

In Fig. 3 ist die Zeitabhängigkeit des Auslaugens von Indium durch α-102- und TBC (Triäthanolamin/Butylcellosolve)-Flußmittel aufgetragen. Nach einer Anlaufzeit für das α-102 Flußmittel findet ein sehr schnelles Auslaugen statt, wobei die Geschwindigkeit mit der Abnahme der Indiumkonzentration abfällt. Die durch das TBC-Flußmittel ausgelaugte Menge nahm mit konstanter Geschwindigkeit ab.

In Fig. 4 ist die Zeitabhängigkeit des Auslaugens von Indium durch das α-102 Flußmittel bei verschiedenen Temperaturen dargestellt, wobei die 250°-Kurve wahrscheinlich die gleiche Form wie die 280°-Kurve haben dürfte, wenn zusätzliche Punkte gemessen werden. Es sei bemerkt, daß der Indiumgehalt nach 5 Min. bei 350 °C im wesentlichen der gleiche ist wie nach einer halben Stunde bei 280 °C.

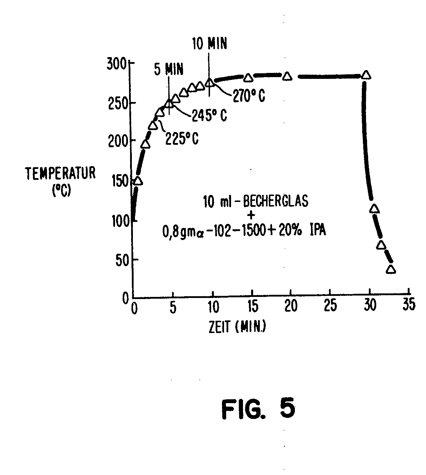

Die Zeit in den zuvor beschriebenen Experimenten ist die Gesamtzeit im Ofen. In Fig. 5 ist das thermische Profil eines Ofens, der auf 280 °C erhitzt ist, dargestellt. Dieses wurde erhalten, indem man das Thermoelement in einem Becherglas mit Flußmittel befestigte und die Temperaturen des in den Ofen gestellten Becherglases bestimmte. Alle Bedingungen waren den experimentellen Bedingungen ähnlich. Nach 5 Minuten beträgt die Temperatur nur 245 °C, was die Anlaufzeit, die in den Fign. 3 und 4 angegeben ist, zu erklären scheint.

Eine Überprüfung der ungefähren Löslichkeit von Indium in Abietinsäure wurde durchgeführt, indem 500 mg Stücke von reinem Indium in bekannte Gewichtsmengen von Abietinsäure gegeben wurde. Die Ergebnisse für 200 °C und 280 °C sind in der nachfolgenden Tabelle V angegeben.

Tabelle V

Löslichkeit* von reinem Indium in Abietinsäure nach dem Auslaugen (durch Gewichtsverlust bestimmt)

Löslichkeit

200 °C 44 Std.  5,1 bis 6,8 % Indium
280 °C 19 Std.  6   bis 10  % Indium

* nicht unbedingt im Gleichgewicht ;

Indium und Abietinsäure wurden durch Differentialkalorimetermessungen und Differentialthermoanalyse analysiert, Ergebnisse nicht überzeugend.

Für die Werte in dieser Tabelle wurde der Gewichtsverlust von Indium bestimmt und die Löslichkeiten berechnet. Es sind zwei Löslichkeitswerte angegeben, bezogen auf das anfängliche und das Endgewicht des Harzes, weil beim Erhitzen ein Verlust an Abietinsäure auftritt. Der Löslichkeitsunterschied zwischen 200 und 280 °C ist nicht groß genug, um die Ergebnisse der Auslaugversuche, die in Tabelle III angegeben und in Fig. 2 aufgezeichnet sind, zu erklären.

Da die Löslichkeit von Indium bei 280 °C in Kolophonium in der Größenordnung von 10 % liegt, würde eine Herabsetzung des Kolophoniums in dem Flußmittel die entfernte Menge Indium auch herabsetzen. Die Auswirkungen der Änderung des Gewichtsverhältnisses von Kolophonium zu dem 50 : 50 Indium-/Bleilot wurden bei 280 °C untersucht (tatsächliche Temperatur der Probe 285 °C). Es wurde Kolophonium im Verhältnis 1 : 1 und 5 : 1 zu dem 50 : 50 Indium/Bleilot verwendet. Ein 200 mg Stück von 50 : 50 Indium/Blei wurde in ein Becherglas mit dem gewünschten Gewicht an Kolophonium gegeben. Die Ergebnisse sind in Tabelle VI aufgezeichnet.

Tabelle VI

Untersuchungen über die gelöste Indiummenge als Funktion des Verhältnisses Kolophonium: 50 : 50 Indium/Bleilot.

| | 285 °C | | | | | |
|---|---|---|---|---|---|---|
| Verhältnis | 1 : 1 | | | 5 : 1 | | 200 : 1 |
| | % restl. Indium | | | % restl. Indium | | % restl. Indium |
| Zeit | Gew. Verlust | | DSC | Gew. Verlust | DSC | DSC** |
| 1/2 Std. | — | | — | — | — | 8 % |
| 1 Std. | 47 | | 47 | 42 | 42 | — |
| 4 Std. | 49 | | 47 | 29 | 34 | — |
| 12 Std. | — | | — | 27 | 26 | — |
| 15 Std. | 45 | | 46 | — | — | — |

* aus Ergebnissen an Chip-Anschlußstellen
** aus Differentialkalorimetermessungen

Wie zu erwarten ist, ist die Herabsetzung des Indiumgehalts in der Legierung um so größer, je größer der Kolophoniumanteil ist. Zum Vergleich werden Ergebnisse an Chiplötstellen bei Anwendung von Kontaktanschlußstellen gezeigt. Das Sollverhältnis von Kolophonium zu 50 : 50 Indium/Blei war 200 : 1, welches sich um ± 25 % geändert haben mochte. Mit der größeren Menge an Kolophonium, die auf den Chips vorhanden war, wurde eine viel größere Abnahme an Indium in einer viel kürzeren Zeit erreicht.

Ein weiterer Weg, diese Ergebnisse darzustellen, ist, die Konzentration von Indium in dem Kolophonium anzugeben. Diese Ergebnisse sind in Tabelle VII zusammengestellt.

Tabelle VII

Gelöste Indiummenge als Funktion des Verhältnisses Kolophoniumharz : 50 : 50 Indium/Blei ; Indiumkonzentration in Kolophonium (durch Gewichtsverlust bestimmt)

| | 285 °C | | |
|---|---|---|---|
| Verhältnis | 1 : 1 | 5 : 1 | 200 : 1* |
| | % Indium in | % Indium in | % Indium in |
| | Kolophonium | Kolophonium | Kolophonium |
| Zeit | Endwert | Endwert | |
| 1/2 Std. | — | — | 0,2 |
| 1 Std. | 7,3 | 3,4 | — |
| 4 Std. | 4,0 | 7,2 | — |
| 12 Std. | — | 7,8 | — |
| 15 Std. | 13,2 | — | — |

* aus Ergebnissen von Chipanschlußstellen.

Die Ergebnisse sind dargestellt als Zusammensetzungen unter Verwendung der Endgewichte von Kolophonium. Das Kolophonium war höchst wahrscheinlich für das 1 : 1 Gewichtsverhältnis nach 15 Stunden an Indium gesättigt oder nahezu gesättigt. Für das 5 : 1 Verhältnis nach 12 Stunden war das Kolophonium nicht gesättigt und bei den Chips war nur eine Kleine Menge Indium in Lösung, obgleich nahezu alles Indium aus den Lötanschlußstellen entfernt war. Daraus ist klar zu erkennen, daß, je größer das Gewichtsverhältnis von Kolophonium zu 50 : 50 Indium/Bleilegierung ist, desto größer auch, wie zu erwarten ist, der Gehalt an gelöstem Indium ist.

Ein Chip mit 5 : 95 Zinn/Blei wurde 1/2 Stunde lang auf 350 °C erhitzt, und der Zinngehalt wurde mit einem -102 Flußmittel von 5 % auf 3/4 % reduziert. Die Ergebnisse in Tabelle 8 nach der Atomabsorption (AA) zeigen die Daten für kürzere Erhitzungszeiten.

Tabelle VIII

Gelöstes Zinn in einem -102-1 500 Flußmittel bei 350 °C, 2 Minuten, bei mehrfachem nachträglichem Benetzen, Überschuß an Flußmittel

| Probe | Zinngehalt | |
| --- | --- | --- |
| | DSC** | AA* |
| Kontrollprobe gereinigt | 4,6 % | 7,1 % |
| 1 mal Erhitzen zum Benetzen + Flußmittel | 3,1 % | 5,2 % |
| 2 mal Erhitzen zum Benetzen + neues Flußmittel | 2,3 % | 2,7 % |

\* Ergebnisse fraglich, weil das Verfahren für Zinn nicht
\*\* empfindlich genug ist.
Differentialkalorimetermessungen

Obgleich eine Diskrepanz bei Legierungen mit einem höheren Zinngehalt vorliegt, ist ersichtlich, daß Zinn auch aus Zinn/Blei-Loten durch Lötflußmittel auf der Basis von Kolophonium ausgelaugt wird. Chips mit einem Sollwert 5 : 95 Zinn/Blei wurden drei Erhitzungszyklen unterworfen unter Anwendung des α-102-1 500 Flußmittels mit 20 % Isopropylalkohol, wobei jedesmal ein neues Flußmittel angewendet wurde. Der Zinngehalt der Zusammensetzung änderte sich von 4,5 % Zinn auf 3,5 % Zinn, was mit dem Differentialkalorimeter bestimmt wurde.

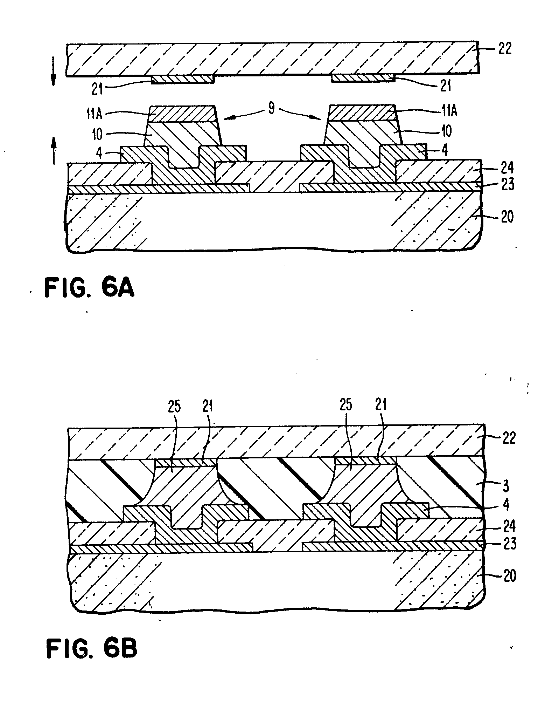

Die Fign. 6A und 6B zeigen Zwischenstufen bei der Herstellung einer modifizierten Lötverbindung eines Chips 20 zu einem Leiterzugmuster 21 auf einem Keramikträger 22. Das integrierte Halbleiterchip 20 enthält, nicht gezeigt, integrierte Schaltkreise. Es ist bedeckt mit einem ersten Aluminiumleiterzugmuster 23, von dem Teile über Kontaktöffnungen in der passivierenden Schicht 24, beispielsweise aus Siliciumdioxid, freigelegt sind. Die Kontaktstellen 4 (wie in Fig. 1) werden über jeder Öffnung in Kontakt mit der darunter liegenden Metallisierung 23 gebildet. Aufeinanderfolgend werden auf jeder Kontaktstelle eine Bleischicht 10 und eine Zinnschicht 11A als doppelschichtige Lötanschlußstelle 9 abgeschieden. Diese doppelschichtige Lötanschlußstelle 9 kann erhitzt werden, um die Zinnschicht 11A mit der Bleischicht 10 unter Ausbildung einer Lötanschlußstelle 25 aus einer 5 : 95 Zinn/Blei-Legierung zu verschmelzen. Das Chip 20 wird dann relativ zum Keramiksubstrat 22 angeordnet zur Herstellung von Lötverbindungen 25 mit der Metallisierung 21 des Keramiksubstrats 22 an den gewünschten Stellen, und die Einheiten werden durch konventionelles Erhitzen miteinander verbunden. Die Hohlräume zwischen dem Chip 20, das mit dem Substrat 22 verbunden ist, werden mit α-102 Flußmittel-3 gefüllt, und die Anordnung wird 1/2 Stunde lang bei 350 °C zum Auslaugen erhitzt. Der Zinngehalt in der Legierung der Lötanschlußstellen 25 wurde auf etwa 0,4 % Zinn herabgesetzt.

**Ansprüche**

1. Verfahren zur in-situ Änderung der Zusammensetzungen von Lötlegierungen mit einem Gehalt an Blei und einem Netzmittel, dadurch gekennzeichnet, daß die Lötlegierungen in geschmolzener Form eine ausreichende Zeit lang in Kontakt mit einem Lötflußmittel erhitzt werden, um den Gehalt an Netzmittel in der geschmolzenen Lötlegierung herabzusetzen.

2. Verfahren nach Anspruch 1, dadurch gekennzeichnet, daß die Lötlegierungen mit einem Gehalt an Zinn oder Indium in geschmolzener Form eine ausreichende Zeit lang in Kontakt mit wenigstens einem Lötflußmittel aus der Gruppe der Monocarbonsäuren eines alkylierten Hydrophenanthrengerüsts mit der allgemeinen Formel $C_{19}H_{29}$ COOH erhitzt werden, um den Gehalt an Zinn oder Indium in der geschmolzenen Lötlegierung herabzusetzen.

3. Verfahren nach Anspruch 2, dadurch gekennzeichnet, daß die Säuren in Form wasserhellen Kolophoniums angewendet werden.

**0 009 131**

4. Verfahren nach den Ansprüchen 1 bis 3, dadurch gekennzeichnet, daß die Lötlegierungen bei Temperaturen oberhalb ihres Schmelzpunkts zwischen den miteinander zu verbindenden Teilen einer integrierten Schaltung aufgetragen und in geschmolzener Form eine ausreichende Zeit lang mit dem Lötflußmittel behandelt werden, um den Gehalt an Zinn oder Indium in der Lötlegierung herabzusetzen.

5. Verfahren nach den Ansprüchen 1 bis 4, dadurch gekennzeichnet, daß die Lötlegierung zur Entfernung von Zinn oder Indium mit dem Lötflußmittel eine ausreichende Zeit lang auf einer bestimmten Temperatur gehalten wird, um die Zusammensetzung der geschmolzenen Lötlegierung bei der gewählten Temperatur so zu ändern, daß sie auf einem Punkt der Solidus-Kurve des Phasendiagramms der Legierung liegt.

6. Verfahren nach den Ansprüchen 1 bis 5, dadurch gekennzeichnet, daß das Lötflußmittel auf Lötlegierungen angewendet wird, die ein integriertes Halbleiterchip mit einem dielektrischen Substrat verbinden, dessen Schaltkreismuster auf die Schaltkreiskonfiguration des Halbleiterchips abgestimmt ist.

## Claims

1. Method for the in-situ modification of the composition of a solder alloy containing lead and a wetting agent, characterized in that the solder alloy is heated in molten form for a sufficient time in contact with a fluxing agent to reduce the content of the wetting agent in the molten solder.

2. Method as claimed in claim 1, characterized in that the solder alloy contains tin or indium and is heated in molten form for a sufficient time in contact with at least one fluxing agent selected from the monocarboxylic acids of alkylated hydrophenanthrene nuclei with the empirical formula $C_{19}H_{29}COOH$ to reduce the content of tin or indium in the molten solder.

3. Method as claimed in claim 2, characterized in that the acid is used in the form of water white rosin.

4. Method as claimed in claims 1 to 4, characterized in that the solder alloy is applied at a temperature above its melting point between the parts of an integrated circuit which are to be interconnected, and is processed in molten form for a sufficient time with the fluxing agent to reduce the content of tin or indium in the solder alloy.

5. Method as claimed in claims 1 to 4, characterized in that for removing tin or indium the solder alloy is kept at a predetermined temperature for a sufficient time to alter the composition of the molten solder at the selected temperature in such a manner that it is a point of the solidus curve of the phase diagram of said alloy.

6. Method as claimed in claims 1 to 5, characterized in that the fluxing agent is used for solder alloys that join an integrated semiconductor chip to a dielectric substrate wherein the circuit pattern is adapted to the circuit configuration of the semiconductor chip.

## Revendications

1. Procédé pour la modification in-situ des compositions d'alliage de soudure contenant du plomb et un agent mouillant, caractérisé en ce que les alliages de soudure, à l'état de fusion, sont chauffés pendant un temps suffisant en contact avec un flux pour réduire la teneur en agent mouillant de l'alliage de soudure en fusion.

2. Procédé selon la revendication 1, caractérisé en ce que les alliages de soudure contenant de l'étain ou de l'indium à l'état de fusion sont chauffés pendant un temps suffisant en contact avec au moins un flux du groupe des acides monocarboxyliques ayant une structure d'hydrophénanthrène alcoylée ayant la formule générale $C_{19}H_{29}COOH$ pour réduire la teneur en étain ou en indium de l'alliage de soudure en fusion.

3. Procédé selon la revendication 2, caractérisé en ce que les acides sont appliqués sous la forme de colophane limpide.

4. Procédé selon l'une quelconque des revendications 1 à 3, caractérisé en ce que les alliages de soudure sont appliqués, à des températures supérieures à leur point de fusion, entre les parties à interconnecter d'un circuit intégré et traités, à l'état de fusion, pendant un temps suffisant avec le flux pour réduire la teneur en étain ou en indium de l'alliage de soudure.

5. Procédé selon l'une quelconque des revendications 1 à 4, caractérisé en ce que l'alliage de soudure servant à enlever l'étain ou l'indium est maintenu, avec le flux, pendant un temps suffisant à une température prédéterminée pour modifier la composition de l'alliage de soudure en fusion à la température choisie de telle sorte qu'il est situé sur un point de la courbe de solidus du diagramme de phase de l'alliage.

6. Procédé selon l'une quelconque des revendications 1 à 5, caractérisé en ce que le flux est appliqué aux alliages de soudure pour lier une microplaquette semi-conductrice intégrée avec un substrat diélectrique dont la configuration de circuits est adaptée à la configuration de circuits de la microplaquette semi-conductrice.

**FIG. 1**

Pb - In - PHASENDIAGRAMM (GLEICHGEWICHT)

**FIG. 2**

1

42% In Pb
NACH DEM AUFDAMPFEN

**FIG. 1A**

8% In Pb
NACH 1/2 STD. BEI 280°C

**FIG. 1B**

**FIG. 3**

**FIG. 4**

3

FIG. 5

**FIG. 6A**

**FIG. 6B**